# EUROPÄISCHE PATENTANMELDUNG

(11) **EP 1 752 555 A1**
(43) Veröffentlichungstag der Anmeldung: **14.02.2007**
(21) Anmeldenummer: 05016364.1
(22) Anmeldetag: 28.07.2005
(51) Int. Cl.: C23C 14/26

(54) **Verdampfervorrichtung**

(71) Anmelder: Applied Materials GmbH & Co. KG, 63755 Alzenau (DE)
(72) Erfinder: Bender, Marcus, 63456 Hanau (DE); Hoffmann, Uwe, 63755 Alzenau (DE); Klemm, Günter, 63667 Nidda (DE); Haas, Dieter, 63486 Bruchköbel (DE); Englert, Ulrich, 63869 Heigenbrücken (DE)
(74) Vertreter: Schickedanz, Willi

(57) **Zusammenfassung**

Die Erfindung betrifft eine Verdampfervorrichtung zum Beschichten von Substraten, insbesondere zum Aufbringen einer Aluminiumschicht auf OLEDs. Um hohe Verdampferrohr-Temperaturen zu erreichen, wie sie beispielsweise für die Verdampfung von Materialien mit niedrigem Dampfdruck notwendig sind, ist die Heizung in das Innere des Verdampferrohrs gelegt. Dadurch werden die thermischen Verluste minimiert, und es sind höhere Rohrtemperaturen bei vergleichbar eingekoppelter Heizleistung möglich.

## Beschreibung

Die Erfindung betrifft eine Verdampfervorrichtung nach dem Oberbegriff des Patentanspruchs 1.

Moderne Flachbildschirme weisen für die Wiedergabe von Bildern oder Schriftzeichen Flüssigkristallelemente (LCDs) oder Plasmaelemente auf.

Neuerdings werden auch Flachbildschirme hergestellt, welche organische Leuchtdioden (OLEDs) als Farbpixel verwenden.

Ein großer Vorteil der OLEDs gegenüber den bereits bekannten Bauelementen ist ihr hoher Wirkungsgrad von über 16 % (Helmuth Lemme: OLEDs - Senkrechtstarter aus Kunststoff, Elektronik 2/2000, S. 98, rechte Spalte, 2. Absatz, Nr. [5]: Yi He; Janicky, J.: High Efficiency Organic Polymer Light-Emitting Heterostructure Devices, Eurodisplay 99, VDE-Verlag Berlin, Offenbach). Damit liegen die OLEDs weit über dem Quantenwirkungsgrad der aus anorganischen III-V-Halbleitern bestehenden LEDs.

Ferner haben OLEDs ein geringes Gewicht, weisen einen breiten Abstrahlwinkel auf, bringen eine kräftig leuchtende Farbe mit sich und sind in einem großen Temperaturbereich von -40 °C bis 85 °C einsetzbar. Vorteilhaft ist auch, dass sie bei weniger als 5 Volt betrieben werden können und nur wenig elektrische Energie verbrauchen, wodurch sich die OLEDs insbesondere für den Einbau in batteriebetriebene Geräte anbieten.

Die Herstellung der OLEDs kann mittels der OVPD-Technologie (OVPD = Organic Vapor Phase Deposition) erfolgen, wie sie in US 5 554 220 oder in DE 101 28 091 C1 beschrieben wird. Dabei werden die organischen Materialien auf eine sich auf Glas befindliche Elektrode aufgebracht. Diese Elektrode kann beispielsweise eine ITO-Elektrode (ITO = Indium-Zinn-Oxid) sein, die zuvor auf Glas aufgedampft wurde.

Auf die so entstandene OLED-Schicht können nun weitere Materialien, insbesondere Metalle, aufgetragen werden, die beispielsweise die Funktionen von Steuerelektroden übernehmen. Da OLEDs hitzeempfindlich sind, muss darauf geachtet werden, dass die Hitzeeinwirkung auf OLEDs nicht zu groß wird.

Die Heizaggregate zum Verdampfen von Metallen sind in der Regel um ein Verdampferrohr herum gelagert (DE 38 17 513 C2, DE 101 28 091 C1). Bei diesen Heizaggregaten handelt es sich um vertikale Heizstäbe oder um Spiralheizungen (DE 102 56 038 A1, US 4 880 960). Nachteilig ist bei außerhalb des Verdampferrohrs liegenden Heizaggregaten, dass sie große thermische Verluste aufweisen. Bei der Beschichtung von OLEDs mit Metallen, wo zum Verdampfen der Metalle Temperaturen von über 1200 °C erzeugt werden müssen, beeinträchtigen solche Heizaggregate aufgrund ihrer Wärmeabstrahlung die OLEDs negativ.

Der Erfindung liegt deshalb die Aufgabe zugrunde, eine Verdampfervorrichtung zu schaffen, bei der hoch siedende Substanzen in die Gasphase überführt werden, ohne dass eine zu hohe Wärmeabstrahlung auf ein zu beschichtendes Substrat gelangt.

Diese Aufgabe wird mit einer Verdampfervorrichtung gemäß den Merkmalen des Patentanspruchs 1 gelöst.

Die Erfindung betrifft somit eine Verdampfervorrichtung zum Beschichten von Substraten, insbesondere zum Aufbringen einer Aluminiumschicht auf OLEDs. Um hohe Verdampferrohr-Temperaturen zu erreichen, wie sie beispielsweise für die Verdampfung von Materialien mit niedrigem Dampfdruck notwendig sind, ist die Heizung in das Innere des Verdampferrohrs gelegt. Dadurch werden die thermischen Verluste minimiert, und es sind höhere Rohrtemperaturen bei vergleichbar eingekoppelter Heizleistung möglich.

Der mit der Erfindung erzielte Vorteil besteht insbesondere darin, dass die Heizleistung innerhalb des Verdampferrohrs verbleibt und nicht nach außen abgestrahlt wird. Hierdurch tritt nur eine geringe Verlustleistung auf, und es können sehr hohe Verdampfertemperaturen erzeugt werden. Außerdem ist es möglich, die thermische Isolation des Verdampferrohrs nach außen zu verbessern, da wegen des nun nicht mehr vorhandenen Außenheizers die Isolation direkt am Verdampferrohr anliegen kann. Weiterhin wird eine homogenere Entkopplung der Heizenergie durch die verbesserte Symmetrie des Aufbaus erreicht. Bei den bekannten Verdampfern konnte vor der Austrittsöffnung des Dampfes kein Heizaggregat vorgesehen sein, was teilweise zur Kondensation von Verdampfungsmaterial im Bereich der Austrittsöffnung führte.

Die Erfindung ist anhand der Zeichnungen dargestellt und wird im Folgenden näher erläutert werden. Es zeigen:
Fig. 1 einen Querschnitt durch eine Verdampfervorrichtung;
Fig. 2 eine perspektivische Ansicht eines Teils der Innenwand eines Verdampferrohrs;
Fig. 3 eine perspektivische Ansicht eines Teils der Außenwand des Verdampferrohrs;
Fig. 4eine perspektivische Ansicht eines Verdampferrohrs mit innerhalb des Verdampferrohrs verlaufenden Heizelementen;
Fig. 5 eine perspektivische Ansicht eines Verdampferrohrs mit einer an einer Verdampferleiste anliegenden Heizvorrichtung.

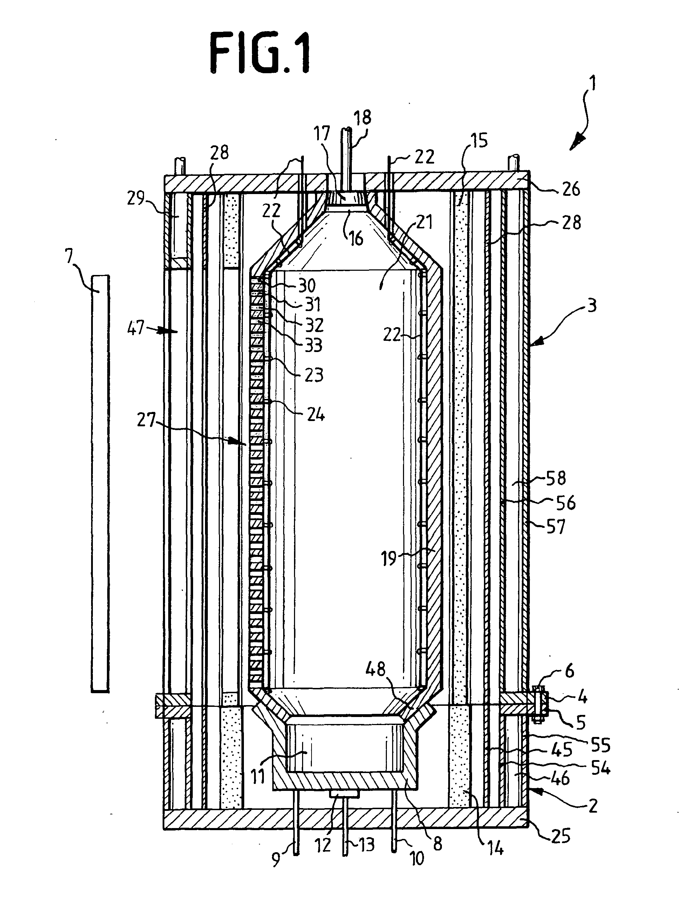

Die Fig. 1 zeigt einen Längsschnitt durch eine Verdampfervorrichtung 1, die einen unteren Gehäuseteil 2 und einen oberen Gehäuseteil 3 aufweist. Der obere Gehäuseteil 3 ist hierbei auf den unteren Gehäuseteil 2 aufgesetzt. Über Verbindungsschellen 4, 5 und einen Verbindungsstift 6 werden der untere und der obere Gehäuseteil 2, 3 zusammengehalten. Während der untere Gehäuseteil 2 auf einem Boden 25 ruht, schließt den oberen Gehäuseteil 3 ein Deckel 26 ab. Statt Verbindungsschellen 4, 5 kann auch eine einfache Steckverbindung vorgesehen sein.

Im Innern des oberen Gehäuseteils 3 befindet sich ein Verdampferrohr 19, das mehrere lineare untereinander angeordnete Düsen 30, 31, 32, 33 aufweist, über die Dampf aus dem Verdampferrohr austreten kann. Dieser Dampf schlägt sich auf der Oberfläche eines Substrats 7 nieder, das an der Verdampfervorrichtung 1 in die Zeichenebene hinein vorbeibewegt werden kann.

Unterhalb des Verdampferrohrs 19 ist ein Tiegel 8 vorgesehen, auf dem das Verdampferrohr 19 über eine Verjüngung 48 ruht. Der Tiegel 8 wird über eine elektrische Heizeinrichtung aufgeheizt; deren Stromzuführungsleitungen mit 9 und 10 bezeichnet sind. Bei der Heizeinrichtung kann es sich beispielsweise um eine nicht dargestellte Spiralheizung handeln, die um den Tiegel 8 herum geschlungen ist. Das Tiegelinnere 11 wird mit einem zu verdampfenden Material befüllt. Auf der Unterseite des Tiegels 8 befindet sich ein Wärmesensor 12, über den die Temperatur des Tiegels 8 gemessen wird. Dieser Wärmesensor 12 ist über einen elektrischen Anschluss 13 mit einem in der Fig. 1 nicht dargestellten Steuerungssystem verbunden, mit dem die Temperatur des Tiegels 8 gesteuert werden kann.

Um den Tiegel 8 herum ist eine Isolierschicht 14 vorgesehen, um die wiederum wenigstens ein Abschirmrohr 45 gelegt ist. Den Abschluss nach außen bildet ein Kühlrohr 46, das durch konzentrisch angeordnete Wände 54, 55 gebildet wird.

Das Verdampferrohr 19 ist ebenfalls von einer rohrförmigen Isolierschicht 15 umgeben, die von einem Abschirmrohr 28 umgeben ist. Die hierauf folgenden und konzentrisch angeordneten zylindrischen Wände 56, 57 bilden zwischen sich einen Kühlraum 58.

Das Verdampferrohr 19 schließt an seinem oberen Ende mit einer Öffnung 16 ab, die mittels eines Stempels 17 und eines Stabs 18 verschlossen werden kann.

Bei den Kühlräumen 58 und 46 handelt es sich um getrennt steuerbare Kühlräume, durch die ein Kühlmittel fließen kann.

Um eine Kondensation des aus dem Tiegel 8 aufsteigenden Dampfs an dem Verdampferrohr 19 zu verhindern, ist an der Innenseite des Verdampferrohrs 19 eine Heizvorrichtung 22 vorgesehen. Hierbei handelt es sich vorzugsweise um eine elektrische Heizung 22, die in der Fig. 1 nur schematisch dargestellt ist. Sie kann beispielsweise aus stabförmigen Heizstäben bestehen, die von elektrisch isolierenden Abstandshaltern 23, 24 gehalten werden.

Durch diese innere Heizvorrichtung 22 kann im Innern 21 des Verdampferrohres 19 eine sehr hohe Temperatur erreicht werden, sodass sogar Materialien mit einem niedrigen Dampfdruck nicht kondensieren.

Die Heizstäbe müssen im Verdampferrohr nicht symmetrisch angebracht werden, sodass es möglich ist, durch geschickte geometrische Anordnung der Heizstäbe auch Stellen zu beheizen, an denen große thermische Verluste auftreten, wie z. B. an den Austrittsöffnungen 30 bis 33 des Verdampferrohrs 19.

Die Heizstäbe können statt auf der inneren Oberfläche des Verdampferrohrs 19 auch gebündelt in dessen Zentrum angeordnet sein.

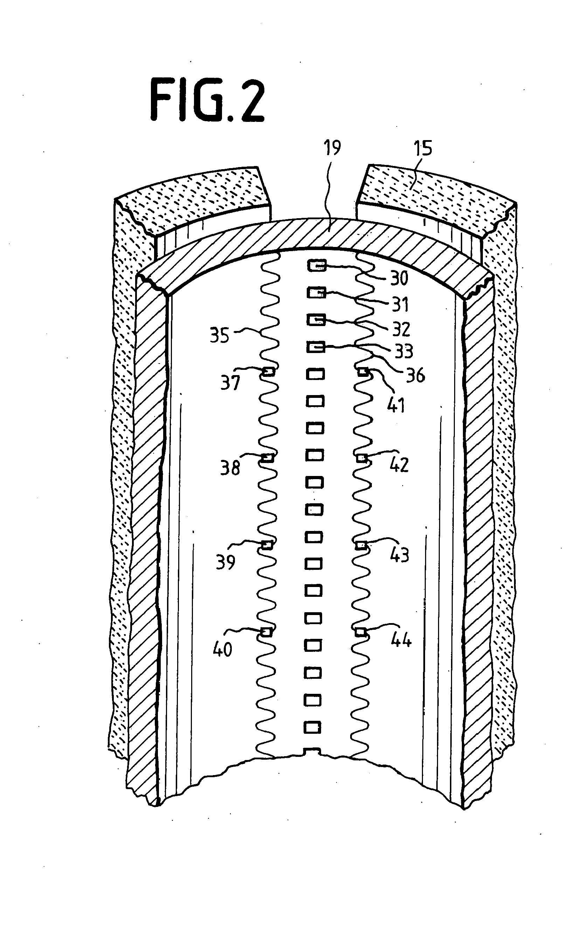

Die Fig. 2 zeigt einen perspektivischen Ausschnitt der Innenseite des Verdampferrohrs 19 mit der Isolierschicht 15. Zu erkennen sind mehrere linear übereinander angeordnete Düsen 30 bis 33, aus denen der Dampf von innen nach außen austreten kann. Die Düsen 30 bis 33 bilden somit ein lineares Verteilersystem, wodurch der Dampf senkrecht auf die Oberfläche des Substrats 7 trifft.

Zu beiden Seiten der Düsen 30 bis 33 verlaufen zwei mäanderförmig ausgebildete Heizelemente 35, 36, die über elektrisch isolierende Abstandshalter 37 bis 40 bzw. 41 bis 44 mit der Innenwand des Verdampferrohrs 19 verbunden sind. Die Stromquelle, welche die Heizelemente 35, 36 mit elektrischer Energie versorgt, ist in der Fig. 2 nicht dargestellt.

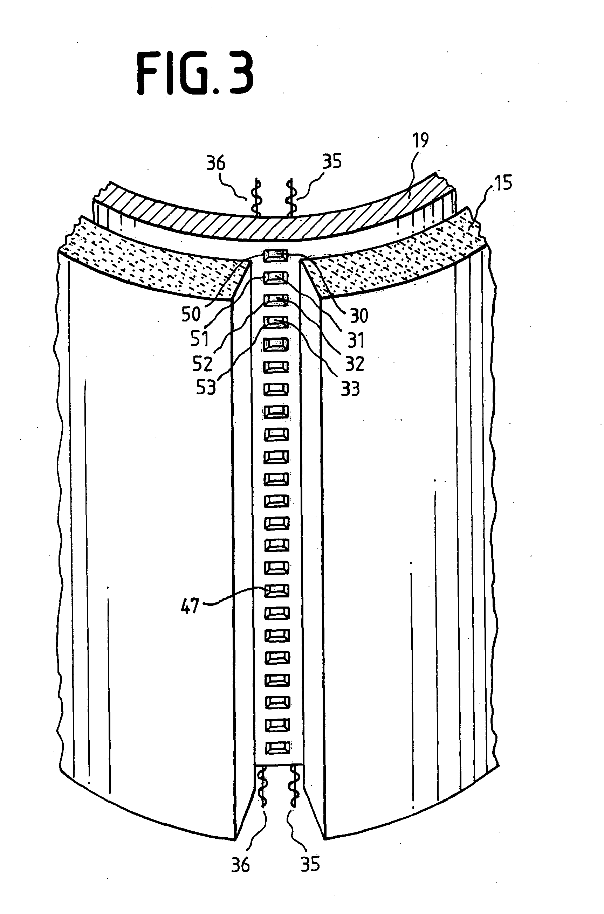

Die Fig. 3 zeigt einen perspektivischen Ausschnitt der Außenseite des Verdampferrohrs 3 mit dem Verdampferrohr 19 und der Isolierschicht 15. Die Isolierschicht 15 umschließt das Innenrohr 19 fast vollständig, wobei sie ein keilförmiges Fenster 47 offen lässt. In diesem Fenster 47 sind die Düsen 30 bis 33 linear übereinander angeordnet, wobei sich diese Düsen 30 bis 33 nach außen hin schießschartenartig vergrößern. Die Vergrößerungen sind mit 50 bis 53 bezeichnet.

Zur besseren Abschirmung des inneren Rohrs 19 und der Isolierschicht 15 können noch weitere Abschirmrohre (vgl. 28 in Fig. 1) vorgesehen sein. Diese müssen dann Fenster aufweisen, die an das Fenster der Isolierschicht 15 anschließen. Derartige Abschirmrohre weisen eine unterschiedlich hohe Wärmeleitfähigkeit auf, wobei vorzugsweise die Wärmeleitfähigkeit von innen nach außen abnimmt.

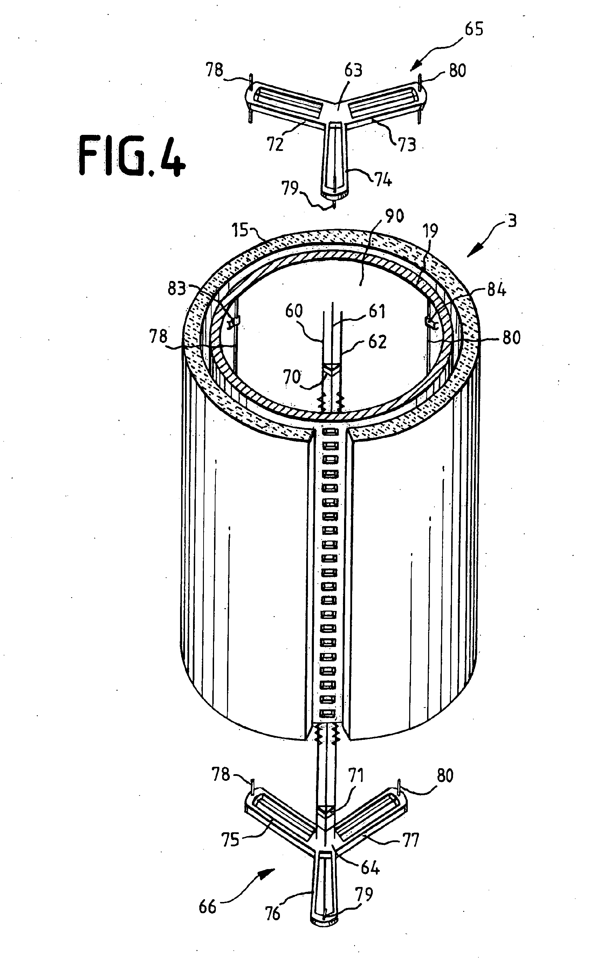

Die Fig. 4 zeigt eine perspektivische Ansicht des Verdampferrohrs 19 mit der Isolierschicht 15, wobei Heizelemente 60 bis 62 durch die Mitte des Verdampferrohrs 3 geführt sind. Diese Heizelemente 60 bis 62 verlaufen durch die Zentren 63, 64 zweier parallel zueinander angeordneter Y-förmiger Träger 65, 66 mit jeweils drei Stegen 72 bis 74 bzw. 75 bis 77. Dabei ist der Träger 66 in dem unteren Bereich des Verdampferrohrs angebracht, der über dem Tiegel liegt, während der obere Steg 65 knapp unterhalb des oberen Endes des Verdampferrohrs 19 angebracht ist.

Um einen möglichen Kontakt zwischen den Heizelementen 60 bis 62 zu vermeiden, werden diese durch elektrisch isolierende Abstandshalter 70, 71 in Form eines Dreiecks getrennt, die in vertikaler Richtung in einem gewissen Abstand zueinander angeordnet sind.

Zusätzlich zu den inneren Heizstäben 60 bis 62 können auch noch äußere Heizstäbe 78 bis 80 vorgesehen sein, die durch die Enden der Stege 72 bis 74 bzw. 75 bis 77 geführt sind. Die Heizstäbe 78 bis 80 verlaufen dann weiter über Abstandshalter 83, 84 entlang der Innenwand 90 des Verdampferrohrs 19. Die Heizstäbe 78 bis 80 können selbstverständlich auch ohne die Heizelemente 60 bis 62 vorgesehen sein.

Es können auch Träger eingebaut werden, die noch mehr Stege besitzen, wodurch auch mehr Heizelemente untergebracht werden können. Auch können an einem Ende des Stegs mehrere Heizelemente austreten und entlang der Rohrwand verlaufen, wodurch die Heizleistung noch weiter gesteigert werden kann.

Es versteht sich, dass die Träger und die Heizelemente aus einem Material bestehen müssen, welches eine hohe Hitzbeständigkeit aufweist.

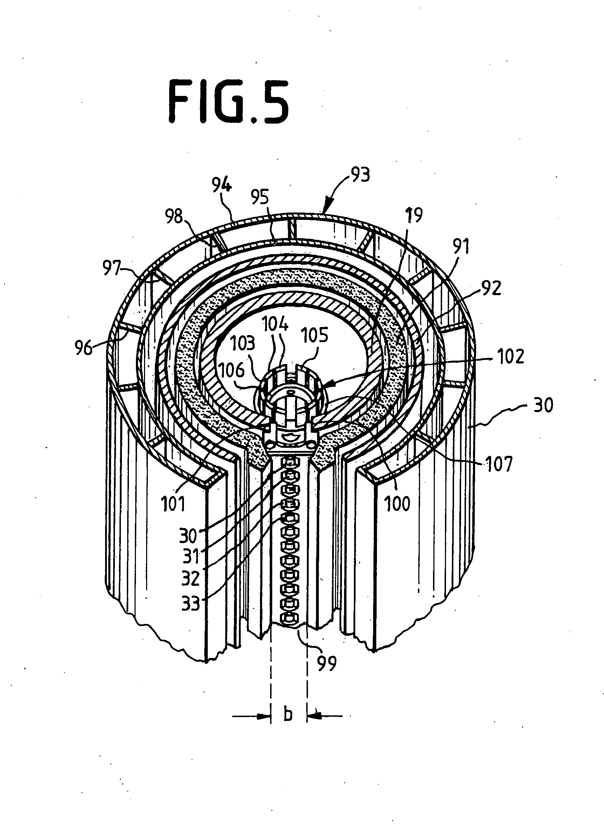

Die Fig. 5 zeigt eine weitere Anordnung einer Innenheizung für ein Verdampferrohr 90. Das Verdampferrohr 90 ist dabei von einer Isolationsschicht 91 umgeben, die ihrerseits von einem Abschirmblech 92 umgeben ist. Ein Kühlrohr 93 umgibt das Abschirmblech 92, wobei dieses Kühlrohr 93 zwei konzentrisch zueinander verlaufende Wände 94, 95 besitzt, zwischen denen in Abständen zueinander Trennungsstege 96 bis 98 verlaufen. Diese Trennungsstege 96 bis 98 bilden zusammen mit den Wänden 94, 95 Kanäle, durch welche Kühlflüssigkeit strömen kann. Eine Düsenleiste 99 mit den Düsen 30 bis 32 ist an die Enden 100, 101 des Verdampferrohrs 90 angeflanscht. Unmittelbar hinter der Düsenleiste 99 befindet sich ein Innenheizer 102, der aus mehreren auf einem Kreis angeordneten Stabheizern 103 bis 105 besteht. Diese Stabheizer 103 bis 105 werden durch innere und äußere Halteringe 106, 107 gestützt. Da die Düsenleiste 99 nach außen vorspringt, entsteht in Verbindung mit dem speziellen Innenheizer 102 eine sehr kleine Abstrahlfläche mit der Breite b.

## Patentansprüche

1. Verdampfervorrichtung zum Beschichten von Substraten, die einen Verdampfer mit einer linearen Verteileröffnung aufweist, **dadurch gekennzeichnet, dass** im Innern des Verdampfers (19, 90) eine Heizung (22; 60 - 62; 78 - 80; 102) vorgesehen ist.

2. Verdampfervorrichtung nach Anspruch 1, **dadurch gekennzeichnet, dass** die Heizung eine elektrische Widerstandsheizung ist.

3. Verdampfervorrichtung nach Anspruch 1, **dadurch gekennzeichnet, dass** die Heizung (60 - 62) im Zentrum des Verdampfers (19, 90) angeordnet ist.

4. Verdampfervorrichtung nach Anspruch 1, **dadurch gekennzeichnet, dass** die Heizung (22) an der Innenwand des Verdampfers (19, 90) angeordnet ist.

5. Verdampfervorrichtung nach Anspruch 1, **dadurch gekennzeichnet, dass** die Heizung (60 - 62; 102) unmittelbar an der linearen Verteileröffnung (30 - 33) angeordnet ist.

6. Verdampfervorrichtung nach Anspruch 1, **dadurch gekennzeichnet, dass** die lineare Verteileröffnung durch eine Düsenleiste (99) gebildet ist und dass unmittelbar gegenüber der Verdampferleiste eine Heizung (102) vorgesehen ist.

7. Verdampfervorrichtung nach Anspruch 1, **dadurch gekennzeichnet, dass** die Heizung mehrere Heizstäbe (103 - 105) enthält.

8. Verdampfervorrichtung nach Anspruch 1, **dadurch gekennzeichnet, dass** der Verdampfer (19, 90) rohrförmig ausgebildet ist.

9. Verdampfervorrichtung nach Anspruch 1, **dadurch gekennzeichnet, dass** die Heizung mäanderförmig ausgebildete Heizelemente (35, 36) aufweist.

10. Verdampfervorrichtung nach Anspruch 1, **dadurch gekennzeichnet, dass** die Heizung stabförmig ausgebildete Heizelemente (103 - 105) umfasst.

11. Verdampfervorrichtung nach Anspruch 7, **dadurch gekennzeichnet, dass** die Heizstäbe einen Zylinder bilden.

## Geänderte Patentansprüche

### Geänderte Patentansprüche gemäss Regel 86(2) EPÜ.

**1.** Verdampfervorrichtung zum Beschichten von Substraten, die einen Verdampfer (19, 90) mit einem linearen Verteiler (30 - 33) sowie eine Heizung aufweist, wobei die Oberfläche des zu verdampfenden Materials in einer ersten Ebene verläuft, **dadurch gekennzeichnet, dass** der lineare Verteiler (30 - 33) in einer zweiten, senkrecht zur ersten Ebene verlaufenden Ebene angeordnet und die Heizung (22; 60 - 62; 78 - 80; 102) im Innern des Verdampfers (19, 90) vorgesehen ist.
